# EUROPÄISCHE PATENTSCHRIFT

(11) **EP 1 105 890 B1**
(45) Veröffentlichungstag und Bekanntmachung des Hinweises auf die Patenterteilung: **18.12.2002**
(21) Anmeldenummer: 99950494.7
(22) Anmeldetag: 02.08.1999
(51) Int. Cl.: H01F 10/08, H01L 43/08, G11C 11/15, G11C 11/155, G11C 11/16

(54) **MAGNETORESISTIVES ELEMENT UND DESSEN VERWENDUNG ALS SPEICHERELEMENT IN EINER SPEICHERZELLENANORDNUNG**
MAGNETORESISTIVE ELEMENT AND THE USE THEREOF AS STORAGE ELEMENT IN A STORAGE CELL ARRAY
ELEMENT MAGNETORESISTIF ET SON UTILISATION COMME ELEMENT DE MEMOIRE DANS UN ENSEMBLE DE CELLULES DE MEMOIRE

(30) Priorität: 12.08.1998 DE 19836568
(43) Veröffentlichungstag der Anmeldung: 13.06.2001
(73) Patentinhaber: Infineon Technologies AG, 81669 München (DE)
(72) Erfinder: SCHWARZL, Siegfried, D-85579 Neubiberg (DE)
(74) Vertreter: Hermann, Uwe, Dipl.-Ing.
(86) Internationale Anmeldenummer: DE9902387
(87) Internationale Veröffentlichungsnummer: WO00010178

(56) Entgegenhaltungen:
- DAUGHTON J M: "MAGNETIC TUNNELING APPLIED TO MEMORY (INVITED)" JOURNAL OF APPLIED PHYSICS,US,AMERICAN INSTITUTE OF PHYSICS. NEW YORK, Bd. 81, Nr. 8, PART 02A, 15. April 1997 (1997-04-15), Seiten 3758-3763-3763, XP000702683 ISSN: 0021-8979
- TEHRANI S ET AL: "HIGH DENSITY NONVOLATILE MAGNETORESISTIVE RAM" INTERNATIONAL ELECTRON DEVICES MEETING (IEDM),US,NEW YORK, IEEE, 8. Dezember 1996 (1996-12-08), Seite 193-196 XP000753747 ISBN: 0-7803-3394-2 in der Anmeldung erwähnt

## Beschreibung

Magnetoresistive Elemente, auch Magnetowiderstandselement genannt, werden zunehmend als Sensorelement oder als Speicherelement für Speicherzellenanordnungen, sogenannte MRAM, verwendet (siehe S. Mengel, Technologieanalyse Magnetismus Band 2, XMR-Technologien, Herausgeber VDI Technologiezentrum Physikalische Technologien, August 1997). Als magnetoresistives Element wird in der Fachwelt eine Struktur verstanden, die mindestens zwei ferromagnetische Schichten und eine dazwischen angeordnete nichtmagnetische Schicht aufweisen. Je nach Aufbau der Schichtstruktur wird dabei unterschieden zwischen GMR-Element, TMR-Element und CMR-Element.

Der Begriff GMR-Element wird in der Fachwelt für Schichtstrukturen verwendet, die mindestens zwei ferromagnetische Schichten und eine dazwischen angeordnete nichtmagnetische, leitende Schicht aufweisen und den sogenannten GMR-(giant magnetoresistance)Effekt zeigen. Unter dem GMR-Effekt wird die Tatsache verstanden, daß der elektrische Widerstand des GMR-Elementes abhängig davon ist, ob die Magnetisierungen in den beiden ferromagnetischen Schichten parallel oder antiparallel ausgerichtet sind. Der GMR-Effekt ist im Vergleich zum sogenannten AMR-(anisotropic magnetoresistance)Effekt groß. Als AMR-Effekt wird die Tatsache verstanden, daß der Widerstand in magnetisierten Leitern parallel und senkrecht zur Magnetisierungsrichtung verschieden ist. Bei dem AMR-Effekt handelt es sich um einen Volumeneffekt, der in ferromagnetischen Einfachschichten auftritt.

Der Begriff TMR-Element wird in der Fachwelt für Tunneling Magnetoresistance Schichtstrukturen verwendet, die mindestens zwei ferromagnetische Schichten und eine dazwischen angeordnete isolierende, nichtmagnetische Schicht aufweisen. Die isolierende Schicht ist dabei so dünn, daß es zu einem Tunnelstrom zwischen den beiden ferromagnetischen Schichten kommt. Diese Schichtstrukturen zeigen ebenfalls einen magnetoresistiven Effekt, der durch einen spinpolarisierten Tunnelstrom durch die zwischen den beiden ferromagnetischen Schichten angeordnete isolierende, nichtmagnetische Schicht bewirkt wird. Auch in diesem Fall ist der elektrische Widerstand des TMR-Elementes abhängig davon, ob die Magnetisierungen in den beiden ferromagnetischen Schichten parallel oder antiparallel ausgerichtet sind. Die relative Widerstandsänderung beträgt dabei etwa 6 Prozent bis ca. 30 Prozent.

Ein weiterer Magnetowiderstandseffekt, der wegen seiner Größe (relative Widerstandsänderung von 100 bis 400 Prozent bei Raumtemperatur) Collosal Magnetoresistance-Effekt (CMR-Effekt) genannt wird, erfordert wegen seiner hohen Koezitivkräfte ein hohes Magnetfeld zum Umschalten zwischen den Magnetisierungszuständen.

In US-5 477 482 ist vorgeschlagen worden, die ferromagnetischen Schichten und die nichtmagnetische Schicht eines CMR-Elements ringförmig auszubilden, wobei die Ringe aufeinander gestapelt oder konzentrisch ineinander angeordnet sind.

Es ist vorgeschlagen worden (siehe zum Beispiel S. Tehrani et al, IEDM 96-193 und D. D. Tang et a, IEDM 95-997), GMR-Elemente bzw. TMR-Elemente als Speicherelemente in einer Speicherzellenanordnung zu verwenden. Die Speicherelemente werden über Leseleitungen in Reihe geschaltet. Quer dazu verlaufen Wortleitungen, die sowohl gegenüber den Leseleitungen als auch gegenüber den Speicherelementen isoliert sind. An die Wortleitungen angelegte Signale verursachen durch den in der Wortleitung fließenden Strom ein Magnetfeld, das bei hinreichender Stärke die darunter befindlichen Speicherelemente beeinflußt. In der Speicherzellenanordnung wird ausgenutzt, daß sich der Widerstand der Speicherelemente unterscheidet, je nachdem ob die Magnetisierungen in den beiden ferromagnetischen Schichten parallel oder antiparallel zueinander ausgerichtet sind. Zum Einschreiben von Information wird daher die Magnetisierungsrichtung der einen ferromagnetischen Schicht festgehalten, während die der anderen ferromagnetischen Schicht geschaltet wird. Dazu werden sich kreuzende Leitungen, die auch als xy-Leitungen bezeichnet werden und die sich an der zu beschreibenden Speicherzelle kreuzen, so mit Signalen beaufschlagt, daß am Kreuzungspunkt ein für die Ummagnetisierung ausreichendes magnetisches Feld verursacht wird.

Das Festhalten der Magnetisierungsrichtung in der einen ferromagnetischen Schicht erfolgt durch eine benachbarte antiferromagnetische Schicht, die die Magnetisierung festhält (siehe D. D. Tang et al, IEDM 95-997) oder durch unterschiedliche Schichtdicken der ferromagnetischen Schichten (siehe S. Tehrani et al, IEDM 96-193). Dabei weist die antiferromagnetische Schicht eine andere Materialzusammensetzung als die benachbarte ferromagnetische Schicht, deren Magnetisierungszustand festgehalten wird, auf.

Die unterschiedlichen Schichtdicken der beiden ferromagnetischen Schichten bewirken, daß in der einen ferromagnetischen Schicht ein höheres Magnetfeld zur Beeinflussung der Magnetisierungsrichtung erforderlich ist als in der anderen. Zum Einschreiben von Information wird das Magnetfeld so bemessen, daß es nur die Magnetisierungsrichtung in der einen der beiden ferromagnetischen Schichten beeinflussen kann. Die Magnetisierungsrichtung in der anderen ferromagnetischen Schicht, die nur mit einem erhöhten Magnetfeld umschaltbar ist, bleibt somit davon unbeeinflußt.

Da die Schichtdicke der ferromagnetischen Schicht einerseits aus fertigungstechnischen Gründen eine minimale Schichtdicke von etwa 5 nm nicht unterschreiten kann, andererseits die maximale Schichtdicke der ferroelektrischen Schicht in einem GMR- oder TMR-Element ebenfalls begrenzt ist durch die Tatsache, daß eine definierte Magnetisierungsrichtung parallel zur Schichtebene vorliegen muß, ist in diesem Fall eine genaue Einstellung des Schaltmagnetfeldes erforderlich.

Der Erfindung liegt das Problem zugrunde, ein magnetoresistives Element anzugeben, das im Rahmen einer Halbleiterprozeßtechnik mit guter Ausbeute herstellbar ist und das bezüglich der Einstellung des Schaltmagnetfeldes unempfindlich ist.

Dieses Problem wird erfindungsgemäß gelöst durch ein magnetoresistives Element gemäß Anspruch 1, 4 oder 7. Ausgestaltungen der Erfindung gehen aus den Unteransprüchen hervor.

Das magnetoresistive Element ist unter anderem vorteilhaft verwendbar als Speicherelement in einer Speicherzellenanordnung. Darüber hinaus ist das magnetoresistive Element als Sensorelement einsetzbar.

Das magnetoresistive Element weist ein erstes ferromagnetisches Schichtelement, ein nichtmagnetisches Schichtelement und ein zweites ferromagnetisches Schichtelement auf, die so angeordnet sind, daß das nichtmagnetische Schichtelement zwischen dem ersten ferromagnetischen Schichtelement und dem zweiten ferromagnetischen Schichtelement angeordnet ist. Dabei weist das nichtmagnetische Schichtelement sowohl zu dem ersten ferromagnetischen Schichtelement als auch zu dem zweiten ferromagnetischen Schichtelement jeweils eine Grenzfläche auf. Das erste ferromagnetische Schichtelement und das zweite ferromagnetische Schichtelement weisen im wesentlichen das gleiche Material auf. Das erste ferromagnetische Schichtelement und das zweite ferromagnetische Schichtelement weisen in mindestens einer Dimension parallel zur Grenzfläche zu dem nichtmagnetischen Schichtelement unterschiedliche Abmessungen auf.

Durch diese unterschiedliche Formgebung des ersten ferromagnetischen Schichtelementes und des zweiten ferromagnetischen Schichtelementes unterscheiden sich die Magnetfelder, die erforderlich sind, um die Magnetisierungsrichtungen in den ferromagnetischen Schichtelementen umzuschalten. Dieser Effekt wird als Formanisotropie bezeichnet. Da in jedem Schichtelement die Abmessungen senkrecht zur Schichtdicke deutlich größer sind als die Schichtdicke, sind in diesem magnetoresistiven Element größere Unterschiede in dieser Abmessung möglich als dies in dem in S. Tehrani et al, IEDM 96-193, vorgeschlagenen Element bezüglich der Schichtdicke möglich ist. Diese größeren Unterschiede in der Abmessung bewirken deutlich unterschiedliche Magnetfeldstärken, die zum Umschalten der Magnetisierungsrichtung in der jeweiligen Schicht erforderlich sind. Damit ist das magnetoresistive Element unempfindlicher bezüglich der genauen Einstellung des Schaltmagnetfeldes.

Da das erste ferromagnetische Schichtelement und das zweite ferromagnetische Schichtelement im wesentlichen aus dem gleichen Material bestehen, kann das magnetoresistive Element im Rahmen einer Halbleiterprozeßtechnik, insbesondere Siliziumprozeßtechnik mit den dort auftretenden Temperaturbelastungen etwa 450°C hergestellt werden. In diesem Temperaturbereich ist aufgrund der Diffusionsbeweglichkeit der in magnetoresistiven Schichtsystemen enthaltenen Elemente, insbesondere Fe, Co, Ni, Cu etc., mit einer Diffusion zu rechnen, die die Eigenschaften der ferromagnetischen Schichtelemente verändert. Aufgrund der befürchteten Diffusion kommt es zu einer Veränderung der Materialzusammensetzung in den Grenzflächenzonen, die den spinabhängigen Elektronentransport, auf dem die Magnetowiderstandseffekte in diesen Elementen beruhen, beeinträchtigt. Es wird daher erwartet, daß bereits geringe diffusionsbedingte Materialwanderungen mit einer Reichweite im Bereich von 1 bis 5 nm über diese Grenzflächen hinweg zu erheblichen Veränderungen der magnetischen und elektrischen Eigenschaften führen. Der Einsatz einer antiferromagnetischen Schicht zum Festhalten der Magnetisierungsrichtung in einer der ferromagnetischen Schichten erscheint damit ebenfalls problematisch, da die antiferromagnetische Schicht sich bezüglich der Materialzusammensetzung von der ferromagnetischen Schicht unterscheiden muß und durch diese Diffusionsvorgänge zwischen den benachbarten Schichten mit einer Veränderung der Materialzusammensetzung zu rechnen ist.

Dieses Problem wird in dem erfindungsgemäßen magnetoresistiven Element dadurch gelöst, daß die beiden ferromagnetischen Schichtelemente im wesentlichen aus dem gleichen Material bestehen, so daß zwischen den beiden ferromagnetischen Schichtelementen kein Konzentrationsgradient auftritt. Durch den fehlenden Konzentrationsgradienten zwischen den beiden ferromagnetischen Schichtelementen verschwindet die Triebkraft für einen diffusionsbedingten Materialtransport über das nichtmagnetische Schichtelement hinaus.

Parallel zur Grenzfläche zu dem nicht magnetischen Schichtelement können die ferromagnetischen Schichtelemente einen beliebigen Querschnitt aufweisen.

Gemäß einer Ausgestaltung der Erfindung sind das erste ferromagnetische Schichtelement, das nichtmagnetische Schichtelement und das zweite ferromagnetische Schichtelement als ebene Schichtelemente ausgebildet, die zu einem Schichtstapel zusammengefügt sind. In diesem Fall unterscheiden sich in mindestens einer Dimension, die senkrecht zur Richtung der Schichtenfolge ist, die Abmessungen des ersten ferromagnetischen Schichtelements und des zweiten ferromagnetischen Schichtelements. Es liegt dabei im Rahmen der Erfindung, daß die erste ferromagnetische Schicht und die zweite ferromagnetische Schicht in einer Dimension senkrecht zur Schichtenfolge im wesentlichen die gleichen Abmessungen aufweisen.

Vorzugsweise liegen die Dicken der ferromagnetischen Schichtelemente zwischen 2 nm und 20 nm. Senkrecht zur Schichtdicke beträgt die Abmessung des ersten ferromagnetischen Schichtelements 50 nm x 80 nm bis 250 nm x 400 nm und des zweiten Schichtelements 65 nm x 80 nm bis 350 nm x 400 nm, wobei in einer Dimension ein Unterschied von mindestens 20 Prozent bis 30 Prozent besteht. Der Querschnitt des ersten ferromagnetischen Schichtelements und des zweiten ferromagnetischen Schichtelements ist dabei vorzugsweise im wesentlichen rechteckig. Er kann aber auch rund, oval oder mehreckig sein.

Gemäß einer weiteren Ausgestaltung der Erfindung sind das erste ferromagnetische Schichtelement, das nichtmagnetische Schichtelement und das zweite ferromagnetische Schichtelement jeweils ringförmig ausgestaltet, wobei sich die Ringbreiten des ersten ferromagnetischen Schichtelementes und des zweiten ferromagnetischen Schichtelementes unterscheiden. Das erste ferromagnetische Schichtelement, das nichtmagnetische Schichtelement und das zweite ferromagnetische Schichtelement weisen die Form eines Hohlzylinders auf und sind in Richtung der Hauptachsen der Hohlzylinder gestapelt sind. Die Formanisotropie des magnetischen Schaltfeldes wird in dieser Ausgestaltung durch die unterschiedlichen Ringbreiten, das heißt die halbe Differenz von Außendurchmesser und Innendurchmesser des jeweiligen Hohlzylinders, des ersten ferromagnetischen Schichtelementes und des zweiten ferromagnetischen Schichtelementes realisiert. Die Dicke des ersten ferromagnetischen Schichtelementes und des zweiten ferromagnetischen Schichtelementes beträgt jeweils 2 nm bis 20 nm. Der Außendurchmesser des ersten ferromagnetischen Schichtelementes und des zweiten ferromagnetischen Schichtelementes liegt im Bereich zwischen 50 nm und 400 nm, wobei sich die Außendurchmesser und/ oder Innendurchmesser des ersten ferromagnetischen Schichtelementes und des zweiten ferromagnetischen Schichtelementes um 20 Prozent bis 50 Prozent unterscheiden. Bei einer Ausgestaltung beträgt der Außendurchmesser des ersten ferromagnetischen Schichtelementes 75 nm bis 300 nm und der Außendurchmesser des zweiten ferromagnetischen Schichtelementes 100 nm bis 400 nm.

Gemäß einer weiteren Ausgestaltung der Erfindung sind das erste ferromagnetische Schichtelement, das nichtmagnetische Schichtelement und das zweite ferromagnetische Schichtelement jeweils als Hohlzylinder ausgestaltet und konzentrisch zueinander angeordnet, wobei das nichtmagnetische Schichtelement zwischen dem ersten ferromagnetischen Schichtelement und dem zweiten ferromagnetischen Schichtelement angeordnet ist. Das erste ferromagnetische Schichtelement und das zweite ferromagnetische Schichtelement unterscheiden sich in diesem Fall bezüglich ihrer Höhe parallel zur Zylinderachse.

Die Höhe des ersten ferromagnetischen Schichtelementes liegt vorzugsweise zwischen 50 nm und 250 nm, die Höhe des zweiten ferromagnetischen Schichtelementes zwischen 80 nm und 400 nm, wobei der Unterschied in der Höhe zwischen 30 nm und 150 nm liegt und mindestens 20 bis 30 Prozent betragen sollte. Bei einer anderen Ausgestaltung weist das erste ferromagnetische Schichtelement einen Außendurchmesser zwischen 70 nm und 400 nm, einen Innendurchmesser zwischen 60 nm und 390 nm und eine Höhe parallel zur Hauptachse des Zylinders zwischen 35 nm und 180 nm auf und das zweite ferromagnetische Schichtelement einen Außendurchmesser zwischen 60 nm und 390 nm, einen Innendurchmesser zwischen 50 nm und 380 nm und eine Höhe parallel zur Hauptachse des Zylinders zwischen 50 nm und 400 nm.

Vorzugsweise enthalten die ferromagnetischen Schichtelemente jeweils mindestens eines der Elemente Fe, Ni, Co, Cr, Mn, Gd, Dy. Das nichtmagnetische Schichtelement kann sowohl leitend als auch nichtleitend sein. Vorzugsweise wird das nichtmagnetische Schichtelement nichtleitend vorgesehen und weist mindestens eines der Materialien Al₂O₃, NiO, HfO₂, TiO₂, NbO, und/oder SiO₂ auf und weist eine Abmessung senkrecht zur Grenzfläche zu den ferromagnetischen Schichtelementen im Bereich zwischen 1 und 4 nm auf. In diesem Fall ist das magnetoresistive Element ein TMR-Element, das im Vergleich zu einem GMR-Element einen hohen elektrischen Widerstand senkrecht zur Tunnelschicht aufweist.

Alternativ kann das nichtmagnetische Schichtelement aus leitendem Material, zum Beispiel Cu, Au oder Ag realisiert sein und eine Abmessung senkrecht zur Grenzfläche zu den ferromagnetischen Schichtelementen von 2 nm bis 4 nm aufweisen.

Im folgenden werden Ausführungsbeispiele der Erfindung anhand der Figuren näher erläutert.
- Figur 1a: zeigt eine Aufsicht auf ein magnetoresistives Element mit ebenen Schichtelementen, bei dem sich die Abmessungen eines ersten ferromagnetischen Elementes und eines zweiten ferromagnetischen Elementes senkrecht zu den Magnetisierungsrichtungen unterscheiden.
- Figur 1b: zeigt den in Figur 1a mit Ib-Ib bezeichneten Schnitt.
- Figur 2a: zeigt eine Aufsicht auf ein magnetoresistives Element mit planaren Schichtelementen, bei dem sich die Abmessungen eines ersten ferromagnetischen Schichtelementes und eines zweiten ferromagnetischen Schichtelementes parallel zu den Magnetisierungsrichtungen unterscheiden.
- Figur 2b: zeigt den in Figur 2a mit IIb-IIb bezeichneten Schnitt.
- Figur 3a: zeigt eine Aufsicht auf ein magnetoresistives Element, das übereinander gestapelte, hohlzylinderförmige Schichtelemente, die sich bezüglich ihres Außendurchmessers unterscheiden, aufweist.
- Figur 3b: zeigt den in Figur 3a mit IIIb-IIIb bezeichneten Schnitt.
- Figur 4a: zeigt eine Aufsicht auf ein magnetoresistives Element, das hohlzylinderförmige Schichtelemente aufweist, die konzentrisch zueinander angeordnet sind und die sich bezüglich ihrer Höhe unterscheiden.
- Figur 4b: zeigt den in Figur 4a mit IVb-IVb bezeichneten Schnitt.
- Figur 5: zeigt einen Ausschnitt aus einer Speicherzellenanordnung, die als Speicherelemente magnetoresistive Elemente aufweist.

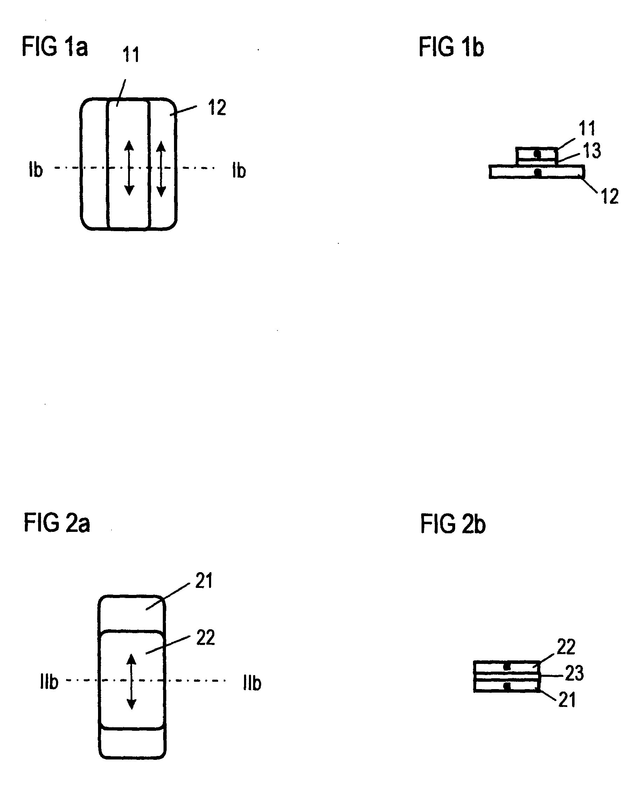

Ein erstes ferromagnetisches Schichtelement 11, ein nichtmagnetisches Schichtelement 13 und ein zweites ferromagnetisches Schichtelement 12 sind als Stapel übereinander angeordnet (siehe Figur 1a, Figur 1b). Das erste ferromagnetische Schichtelement 11 weist eine im wesentlichen rechteckige Form auf mit Abmessungen von 130 nm x 250 nm. In Richtung der Schichtenfolge weist das erste ferromagnetische Schichtelement 11 eine Dicke von 10 nm auf. Das nichtmagnetische Schichtelement 13 weist ebenfalls einen im wesentlichen rechteckigen Querschnitt mit Abmessungen von 130 nm x 250 nm auf. Es weist in Richtung der Schichtenfolge eine Dicke von 2 nm auf. Das zweite ferromagnetische Schichtelement 12 weist einen im wesentlichen rechteckigen Querschnitt mit Abmessungen von 200 nm x 250 nm auf. In Richtung der Schichtenfolge weist es eine Dicke von 10 nm auf.

Das erste ferromagnetische Schichtelement 11 und das nichtmagnetische Schichtelement 13 weisen die gleiche Länge wie das zweite ferromagnetische Schichtelement 12 jedoch eine geringere Breite als das zweite ferromagnetische Schichtelement 12 auf. Das erste ferromagnetische Schichtelement 11 und das nichtmagnetische Schichtelement 13 sind in der Breite mittig auf dem zweiten ferromagnetischen Schichtelement 12 angeordnet. Sowohl in dem ersten ferromagnetischen Schichtelement 11 als auch in dem zweiten ferromagnetischen Schichtelement 12 existieren bevorzugte Magnetisierungsrichtungen parallel zur Länge des jeweiligen Schichtelementes 11, 12. Die Magnetisierungsrichtungen sind in Figur 1a als Doppelpfeile eingetragen.

Das erste ferromagnetische Schichtelement 11 und das zweite ferromagnetische Schichtelement 12 weisen dieselbe Materialzusammensetzung auf. Sie bestehen aus Co. Das nichtmagnetische Schichtelement 13 besteht aus Al₂O₃.

Das erste ferromagnetische Schichtelement 11 weist eine höhere Schaltschwelle als das zweite ferromagnetische Schichtelement auf.

In einem zweiten Ausführungsbeispiel sind ein erstes ferromagnetisches Schichtelement 21 aus Co, ein nichtmagnetisches Schichtelement 23 aus Al₂O₃ und ein zweites ferromagnetisches Schichtelement 22 aus Co übereinander angeordnet (siehe Figur 2a, Figur 2b). Das erste ferromagnetische Schichtelement 21 weist eine im wesentlichen rechteckige Form auf mit einer Länge von 250 nm, einer Breite von 130 nm und einer Dicke in Richtung der Schichtenfolge von 10 nm. Das zweite ferromagnetische Schichtelement 22 weist ebenfalls einen im wesentlichen rechteckigen Querschnitt auf mit einer Länge von 200 nm, einer Breite von 130 nm und einer Dicke in Richtung der Schichtenfolge von 10 nm. Das nichtmagnetische Schichtelement 23 weist den gleichen Querschnitt wie das zweite ferromagnetische Schichtelement 22 auf und eine Dicke parallel zur Schichtenfolge von 2 nm.

In dem ersten ferromagnetischen Schichtelement 21 und in dem zweiten ferromagnetischen Schichtelement 22 werden jeweils Magnetisierungszustände mit Magnetisierungsrichtungen parallel zur Länge des jeweiligen Schichtelementes 21, 22 eingenommen. Die Magnetisierungseinrichtungen sind in Figur 2a als Doppelpfeil eingetragen.

Das zweite ferromagnetische Schichtelement 22 und das nichtmagnetische Schichtelement 23 sind in Richtung der Länge mittig auf dem ersten ferromagnetischen Schichtelement 21 angeordnet. In dieser Anordnung weist das erste ferromagnetische Schichtelement eine höhere Schaltschwelle als das zweite ferromagnetische Schichtelement 22 auf.

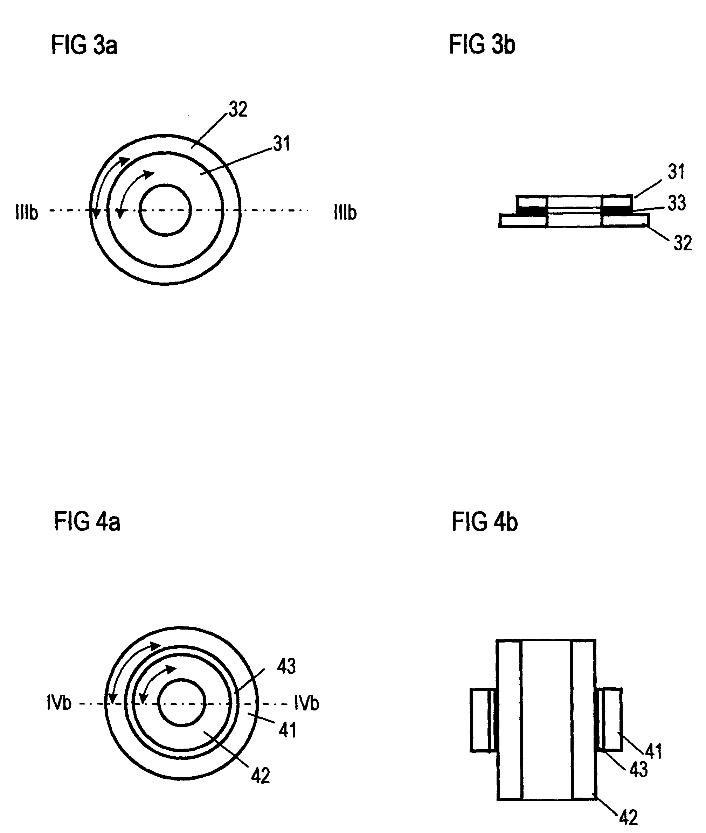

In einem dritten Ausführungsbeispiel weist ein magnetoresistives Element ein erstes ferromagnetisches Schichtelement 31 aus NiFe, ein zweites ferromagnetisches Schichtelement 32 aus NiFe und ein nichtmagnetisches Schichtelement 33 aus Al₂O₃ mit jeweils zylinderförmigem Querschnitt auf (siehe Figur 3a, Figur 3b). Das erste ferromagnetische Schichtelement 31, das nichtmagnetische Schichtelement 33 und das zweite ferromagnetische Schichtelement 32 sind in Richtung der Hauptachsen der Hohlzylinder zu einem Stapel angeordnet, in dem das nichtmagnetische Schichtelement 33 zwischen dem ersten ferromagnetischen Schichtelement 31 und dem zweiten ferromagnetischen Schichtelement 32 angeordnet ist und in dem die Achsen der Zylinder zusammenfallen.

Das erste ferromagnetische Schichtelement 31 und das zweite ferromagnetische Schichtelement 32 weisen jeweils eine Dicke parallel zur Hauptachse von 10 nm auf. In dem ersten ferromagnetischen Schichtelement 31 und dem zweiten ferromagnetischen Schichtelement 32 stellen sich ringförmige Magnetisierungszustände ein, die in Richtung oder in Gegenrichtung des Uhrzeigersinns ausgerichtet sein können.

Das nichtmagnetische Schichtelement 33 weist parallel zur Hauptachse eine Dicke von 2 nm auf. Der Außendurchmesser des ersten ferromagnetischen Schichtelementes 31 beträgt 200 nm, der Außendurchmesser des zweiten ferromagnetischen Schichtelementes 32 beträgt 250 nm, der Innendurchmesser aller Schichtelemente 130 nm.

In dieser Anordnung weist das erste ferromagnetische Schichtelement 31 eine größere Schaltschwelle als das zweite ferromagnetische Schichtelement 32 auf.

Analog können sich die übereinander gestapelten, hohlzylinderförmigen Schichtelemente bezüglich ihres Innendurchmessers oder Innen- und Außendurchmessers unterscheiden.

In einem vierten Ausführungsbeispiel sind ein erstes ferromagnetisches Schichtelement 41 aus NiFe, ein nichtmagnetisches Schichtelement 43 aus Al₂O₃ und ein zweites ferromagnetisches Schichtelement 42 aus NiFe vorgesehen, die jeweils die Form eines Hohlzylinders aufweisen und die konzentrisch zueinander angeordnet sind. Dabei ist das nichtmagnetische Schichtelement 43 zwischen dem ersten ferromagnetischen Schichtelement 41 und dem zweiten ferromagnetischen Schichtelement 42 angeordnet (siehe Figur 4a, Figur 4b).

Das erste ferromagnetische Schichtelement 41 weist einen Außendurchmesser von ca. 270 nm, einen Innendurchmesser von ca. 260 nm und eine Höhe parallel zur Hauptachse des Hohlzylinders von 180 nm auf. Das nichtmagnetische Schichtelement 43 weist einen Außendurchmesser von ca. 260 nm, eine Dicke von 2 nm und eine Höhe parallel zur Hauptachse des Hohlzylinders von mindestens 180 nm auf. Das zweite ferromagnetische Schichtelement 42 weist einen Außendurchmesser von ca. 258 nm, einen Innendurchmesser von ca. 250 nm und eine Höhe parallel zur Hauptachse des Hohlzylinders von 250 nm auf. Das erste ferromagnetische Schichtelement 41 und das nichtmagnetische Schichtelement 43 sind in Bezug auf die Höhe mittig auf dem zweiten ferromagnetischen Schichtelement 42 angeordnet.

In dem ersten ferromagnetischen Schichtelement 41 sowie in dem zweiten ferromagnetischen Schichtelement 42 ist die Magnetisierung ringförmig und kann im Uhrzeigersinn bzw. gegen den Uhrzeigersinn ausgerichtet sein. Die Magnetisierungsrichtung ist in Figur 4a jeweils als Doppelpfeil eingetragen.

In dieser Anordnung weist das erste ferromagnetische Schichtelement 41 eine höhere Schaltschwelle als das zweite ferromagnetische Schichtelement 42 auf.

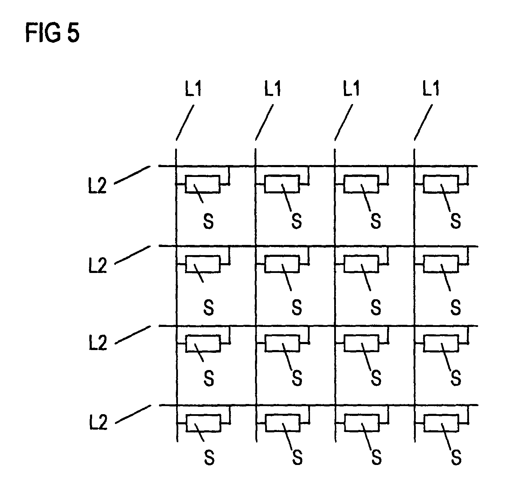

Zum Aufbau einer Speicherzellenanordnung, die als Speicherzelle S magnetoresistive Elemente aufweist, die wie anhand von Figur 1a bis Figur 4b geschildert ausgebildet sind, werden die Speicherelemente S rasterförmig angeordnet (siehe Figur 5). Jedes Speicherelement S ist dabei zwischen eine erste Leitung L1 und eine zweite Leitung L2 geschaltet. Die ersten Leitungen L1 verlaufen untereinander parallel und kreuzen die zweiten Leitungen L2, die untereinander ebenfalls parallel verlaufen. Zum Schreiben eines Speicherelementes S wird an die zugehörige Leitung L1 und die zugehörige zweite Leitung L2 jeweils ein solcher Strom angelegt, daß am Kreuzungspunkt der ersten Leitung L1 und der zweiten Leitung L2, an dem das Speicherelement S angeordnet ist, ein ausreichendes Magnetfeld entsteht, um die Magnetisierungsrichtung des zweiten ferromagnetischen Schichtelementes umzuschalten. Das am jeweiligen Kreuzungspunkt wirksame Magnetfeld ist dabei eine Überlagerung aus dem durch den Stromfluß in der ersten Leitung L1 induzierten Magnetfeldes und des durch den Stromfluß in der zweiten Leitung L2 induzierten Magnetfeldes.

## Patentansprüche

1. Magnetoresistives Element, bei dem
- ein erstes ferromagnetisches Schichtelement (11, 21), ein nichtmagnetisches Schichtelement (13, 23) und ein zweites ferromagnetisches Schichtelement (12, 22) vorgesehen und jeweils als ebenes Schichtelement ausgebildet sind, die übereinander als Stapel so angeordnet sind, dass das nichtmagnetische Schichtelement zwischen dem ersten ferromagnetischen Schichtelement und dem zweiten ferromagnetischen Schichtelement angeordnet ist, wobei das nichtmagnetische Schichtelement zu dem ersten ferromagnetischen Schichtelement und dem zweiten ferromagnetischen Schichtelement jeweils eine Grenzfläche aufweist,
- das erste ferromagnetische Schichtelement und das zweite ferromagnetische Schichtelement im wesentlichen das gleiche Material aufweisen und
- das erste ferromagnetische Schichtelement und das zweite ferromagnetische Schichtelement in einer Dimension senkrecht zur Schichtenfolge im Stapel im wesentlichen die gleichen Abmessungen aufweisen,
**dadurch gekennzeichnet, dass** sich die Abmessungen des ersten ferromagnetischen Schichtelementes (11, 21) und des zweiten ferromagnetischen Schichtelementes (12, 22) in einer Dimension senkrecht zur Schichtenfolge um mindestens 20 Prozent unterscheiden.

2. Magnetoresistives Element nach Anspruch 1, bei dem
sich die Abmessungen des ersten ferromagnetischen Schichtelementes (11, 21) und des zweiten ferromagnetischen Schichtelementes (12, 22) in einer Dimension senkrecht zur Schichtenfolge um mindestens 30 Prozent unterscheiden.

3. Magnetoresistives Element nach Anspruch 1 oder 2, bei dem das erste ferromagnetische Schichtelement (11, 21) senkrecht zur Schichtenfolge Abmessungen von 50 nm x 80 nm bis 250 nm x 400 nm und parallel zur Schichtenfolge eine Dicke zwischen 2 nm und 20 nm aufweist und
das zweite ferromagnetische Schichtelement (12, 22) senkrecht zur Schichtenfolge Abmessungen von 65 nm x 80 nm bis 350 nm x 400 nm und parallel zur Schichtenfolge eine Dicke von 2 bis 20 nm aufweist.

4. Magnetoresistives Element, bei dem
- ein erstes ferromagnetisches Schichtelement (31), ein nichtmagnetisches Schichtelement (33) und ein zweites ferromagnetisches Schichtelement (32) vorgesehen sind, die übereinander als Stapel so angeordnet sind, dass das nichtmagnetische Schichtelement zwischen dem ersten ferromagnetischen Schichtelement und dem zweiten ferromagnetischen Schichtelement angeordnet ist, wobei das nichtmagnetische Schichtelement zu dem ersten ferromagnetischen Schichtelement und dem zweiten ferromagnetischen Schichtelement jeweils eine Grenzfläche aufweist, und
- das erste ferromagnetische Schichtelement und das zweite ferromagnetische Schichtelement im wesentlichen das gleiche Material aufweisen,
**dadurch gekennzeichnet, dass** das erste ferromagnetische Schichtelement (31), das nichtmagnetische Schichtelement (33) und das zweite ferromagnetische Schichtelement (32) jeweils hohlzylinderförmig ausgestaltet sind,
wobei der Außendurchmesser und/oder der Innendurchmesser des ersten ferromagnetischen Schichtelementes (31) sich von dem Außendurchmesser bzw. dem Innendurchmesser des zweiten ferromagnetischen Schichtelementes (32) unterscheidet und
wobei das erste ferromagnetische Schichtelement (31), das nichtmagnetische Schichtelement (33) und das zweite ferromagnetische Schichtelement (32) in Richtung der Hauptachsen der Hohlzylinder gestapelt sind.

5. Magnetoresistives Element nach Anspruch 4, bei dem
die Dicken des ersten ferromagnetischen Schichtelementes (31) und des zweiten ferromagnetischen Schichtelementes (32) jeweils 2 nm bis 20 nm betragen und
die Außendurchmesser des ersten ferromagnetischen Schichtelementes und des zweiten ferromagnetischen Schichtelementes im Bereich zwischen 50 nm und 400 nm liegen,
wobei sich die Außendurchmesser und/oder die Innendurchmesser des ersten ferromagnetischen Schichtelementes und des zweiten ferromagnetischen Schichtelementes um 20 Prozent bis 50 Prozent unterscheiden.

6. Magnetoresistives Schichtelement nach Anspruch 4, bei dem der Außendurchmesser des ersten ferromagnetischen Schichtelementes (31) 75 nm bis 300 nm und die Dicke des ersten ferromagnetischen Schichtelementes (31) parallel zur Hauptachse 2 nm bis 20 nm beträgt und
der Außendurchmesser des zweiten ferromagnetischen Schichtelementes (32) 100 nm bis 400 nm und die Dicke des zweiten ferromagnetischen Schichtelementes (32) parallel zur Hauptachse des Zylinders 2 nm bis 20 nm beträgt.

7. Magnetoresistives Element, bei dem
- ein erstes ferromagnetisches Schichtelement (41), ein nichtmagnetisches Schichtelement (43) und ein zweites ferromagnetisches Schichtelement (42) vorgesehen sind, die so angeordnet sind, dass das nichtmagnetische Schichtelement zwischen dem ersten ferromagnetischen Schichtelement und dem zweiten ferromagnetischen Schichtelement angeordnet ist, wobei das nichtmagnetische Schichtelement zu dem ersten ferromagnetischen Schichtelement und dem zweiten ferromagnetischen Schichtelement jeweils eine Grenzfläche aufweist, und
- das erste ferromagnetische Schichtelement und das zweite ferromagnetische Schichtelement im wesentlichen das gleiche Material aufweisen,
**dadurch gekennzeichnet, dass** das erste ferromagnetische Schichtelement (41), das nichtmagnetische Schichtelement (43) und das zweite ferromagnetische Schichtelement (42) jeweils als Hohlzylinder ausgestaltet sind,
das erste ferromagnetische Schichtelement (41), das nichtmagnetische Schichtelement (43) und das zweite ferromagnetische Schichtelement (42) konzentrisch zueinander angeordnet sind,
wobei das nichtmagnetische Schichtelement (43) in bezüglich der Hohlzylinder radialer Richtung zwischen dem ersten ferromagnetischen Schichtelement (41) und dem zweiten ferromagnetischen Schichtelement (42) angeordnet ist, und
sich das erste ferromagnetische Schichtelement (41) und das zweite ferromagnetische Schichtelement (42) bezüglich ihrer Höhe parallel zur Hauptachse der Zylinder unterscheiden.

8. Magnetoresistives Element nach Anspruch 7, bei dem
die Höhe des ersten ferromagnetischen Schichtelementes (41) zwischen 50 nm und 250 nm liegt,
die Höhe des zweiten ferromagnetischen Schichtelementes (42) zwischen 80 nm und 400 nm liegt und
der Unterschied in der Höhe zwischen 30 nm und 150 nm liegt.

9. Magnetoresistives Element nach Anspruch 7, bei dem
das erste ferromagnetische Schichtelement (41) einen Außendurchmesser zwischen 70 nm und 400 nm, einen Innendurchmesser zwischen 60 nm und 390 nm und eine Höhe parallel zur Hauptachse des Zylinders zwischen 35 nm und 180 nm aufweist, das zweite ferromagnetische Schichtelement (42) einen Außendurchmesser zwischen 60 nm und 390 nm, einen Innendurchmesser zwischen 50 nm und 380 nm und eine Höhe parallel zur Hauptachse des Zylinders zwischen 50 nm und 400 nm aufweist.

10. Magnetoresistives Element nach einem der Ansprüche 1 bis 9, bei dem
das nichtmagnetische Schichtelement (13, 23, 33, 43) mindestens eines der Materialien NiO, HfO₂, TiO₂, NbO, SiO₂ enthält und eine Dicke im Bereich zwischen 1 nm und 4 nm aufweist.

11. Magnetoresistives Element nach einem der Ansprüche 1 bis 10, bei dem
das erste ferromagnetische Schichtelement (11, 21, 31, 41) und das zweite ferromagnetische Schichtelement (12, 22, 32, 42) jeweils mindestens eines der Elemente Cr, Mn, Gd, Dy enthalten.

## Claims

1. Magnetoresistive element wherein
- a first ferromagnetic layer element (11, 21), a nonmagnetic layer element (13, 23) and a second ferromagnetic layer element (12, 22) are provided and are each configured as a planar layer element, which are arranged above one another as a stack in such a way that the nonmagnetic layer element is disposed between the first ferromagnetic layer element and the second ferromagnetic layer. element, the nonmagnetic layer element having one interface each with the first ferromagnetic layer element and the second ferromagnetic layer element, respectively,
- the first ferromagnetic layer element and the second ferromagnetic layer element comprise essentially the same material, and
- the first ferromagnetic layer element and the second ferromagnetic layer element are of essentially the same measurements in a dimension perpendicular to the layer sequence in the stack,
**characterized in that** the measurements of the first ferromagnetic layer element (11, 21) and the second ferromagnetic layer element (12, 22) in a dimension perpendicular to the layer sequence differ by at least 20 per cent.

2. Magnetoresistive element according to Claim 1, wherein
the measurements of the first ferromagnetic layer element (11, 21) and the second ferromagnetic layer element (12, 22) in a dimension perpendicular to the layer sequence differ by at least 30 per cent.

3. Magnetoresistive element according to Claim 1 or 2, wherein
the first ferromagnetic layer element (11, 21) perpendicular to the layer sequence has measurements of from 50 nm × 80 nm to 250 nm × 400 nm and parallel to the layer sequence has a thickness of between 2 nm and 20 nm and
the second ferromagnetic layer element (12, 22) perpendicular to the layer sequence has measurements of from 65 nm x 80 nm to 350 nm × 400 nm and parallel to the layer sequence has a thickness of between 2 nm and 20 nm.

4. Magnetoresistive element wherein
- a first ferromagnetic layer element (31), a nonmagnetic layer element (33) and a second ferromagnetic layer element- (32) are provided, which are arranged above one another as a stack in such a way that the nonmagnetic layer element is disposed between the first ferromagnetic layer element and the second ferromagnetic layer element, the nonmagnetic layer element having one interface each with the first ferromagnetic layer element and the second ferromagnetic layer element, respectively, and
- the first ferromagnetic layer element and the second ferromagnetic layer element comprise essentially the same material,
**characterized in that** the first ferromagnetic layer element (31), the nonmagnetic layer element (33) and the second ferromagnetic layer element (32) are each of hollow cylindrical shape,
where the external diameter and/or the internal diameter of the first ferromagnetic layer element (31) differ from the external diameter or the internal diameter, respectively, of the second ferromagnetic layer element (32) and where the first ferromagnetic layer element (31), the nonmagnetic layer element (33) and the second ferromagnetic layer element (32) are stacked in the direction of the principal axes of the hollow cylinders.

5. Magnetoresistive element according to Claim 4, wherein
the thicknesses of the first ferromagnetic layer element (31) and the second ferromagnetic layer element (32) are each from 2 nm to 20 nm and the external diameters of the first ferromagnetic layer element and of the second ferromagnetic layer element are in the range of between 50 and 400 nm,
wherein the external diameters and/or the internal diameters of the first ferromagnetic layer element and of the second ferromagnetic layer element differ by from 20 per cent to 50 per cent.

6. Magnetoresistive layer element according to Claim 4, wherein
the external diameter of the first ferromagnetic layer element (31) is from 75 nm to 300 nm and the thickness of the first ferromagnetic layer element (31) parallel to the principal axis is from 2 nm to 20 nm and
the external diameter of the second ferromagnetic layer element (32) is from 100 nm to 400 nm and the thickness of the second ferromagnetic layer element (32) parallel to the principal axis of the cylinder is from 2 nm to 20 nm.

7. Magnetoresistive element wherein
- a first ferromagnetic layer element (41), a nonmagnetic layer element (43) and a second ferromagnetic layer element (42) are provided, which are arranged in such a way that the nonmagnetic layer element is disposed between the first ferromagnetic layer element and the second ferromagnetic layer element, the nonmagnetic layer element having one interface each with the first ferromagnetic layer element and the second ferromagnetic layer element, respectively, and
- the first ferromagnetic layer element and the second ferromagnetic layer element comprise essentially the same material,
**characterized in that** the first ferromagnetic layer element (41), the nonmagnetic layer element (43) and the second ferromagnetic layer element (42) are each in the form of a hollow cylinder,
the first ferromagnetic layer element (41), the nonmagnetic layer element (43) and the second ferromagnetic layer element (42) are arranged concentrically relative to one another, the nonmagnetic layer element (43) being disposed, in a radial direction with respect to the hollow cylinders, between the first ferromagnetic layer element (41) and the second ferromagnetic layer element (42), and
the first ferromagnetic layer element (41) and the second ferromagnetic layer element (42) differ in terms of their height parallel to the principal axis of the cylinders.

8. Magnetoresistive element according to Claim 7, wherein
the height of the first ferromagnetic layer element (41) is between 50 nm and 250 nm, the height of the second ferromagnetic layer element (42) is between 80 nm and 400 nm, and
the difference in the height is between 30 nm and 150 nm.

9. Magnetoresistive element according to Claim 7, wherein
the first ferromagnetic layer element (41) has an external diameter of between 70 nm and 400 nm, an internal diameter of between 60 nm and 390 nm and a height, parallel to the principal axis of the cylinder, of between 35 nm and 180 nm,
the second ferromagnetic layer element (42) has an external diameter of between 60 nm and 390 nm, an internal diameter of between 50 nm and 380 nm and a height, parallel to the principal axis of the cylinder, of between 50 nm and 400 nm.

10. Magnetoresistive element according to any one of Claims 1 to 9, wherein
the nonmagnetic layer element (13, 23, 33, 43) comprises at least one of the materials NiO, HfO₂, TiO₂, NbO, SiO₂ and has a thickness in the range of between 1 nm and 4 nm.

11. Magnetoresistive element according to any one of Claims 1 to 10, wherein
the first ferromagnetic layer element (11, 21, 31, 41) and the second ferromagnetic layer element (12, 22, 32, 42) each comprise at least one of the elements Cr, Mn, Gd, Dy.

## Revendications

1. Elément magnétorésistant, dans lequel
- un premier élément (11, 21) ferromagnétique sous forme de couche, un élément (13, 23) amagnétique sous forme de couche et un deuxième élément (12, 22) ferromagnétique sous forme de couche sont prévus et sont constitués respectivement sous la forme d'éléments plans sous forme de couches qui sont superposées en une pile, de façon à ce que l'élément amagnétique sous forme de couche soit interposé entre le premier élément ferromagnétique sous forme de couche et le deuxième élément ferromagnétique sous forme de couche, l'élément amagnétique sous forme de couche ayant, par rapport au premier élément ferromagnétique sous forme de couche et par rapport au deuxième élément ferromagnétique sous forme de couche, respectivement une interface,
- le premier élément ferromagnétique sous forme de couche et le deuxième élément ferromagnétique sous forme de couche sont sensiblement en le même matériau et
- le premier élément ferromagnétique sous forme de couche et le deuxième élément ferromagnétique sous forme de couche ont, dans une dimension perpendiculairement à la succession des couches dans la pile, sensiblement les mêmes dimensions,
**caractérisé en ce que** les dimensions du premier élément (11, 21) ferromagnétique sous forme de couche et du deuxième élément (12, 22) ferromagnétique sous forme de couche dans une direction perpendiculairement à la succession des couches diffèrent d'au moins 20 pour cent.

2. Elément magnétorésistant suivant la revendication 1, dans lequel les dimensions du premier élément (11, 21) ferromagnétiques sous forme de couche et du deuxième élément (12, 22) ferromagnétique sous forme de couche dans une dimension perpendiculairement à la succession des couches diffèrent d'au moins 30 pour cent.

3. Elément magnétorésistant suivant la revendication 1 ou 2, dans lequel le premier élément (11, 21) ferromagnétique sous forme de couche a, perpendiculairement à la succession des couches, des dimensions de 50 nm x 80 nm à 250 nm x 400 nm et, parallèlement à la succession des couches, une épaisseur comprise entre 2 nm et 20 nm et
le deuxième élément (12, 22) ferromagnétique sous forme de couche a, perpendiculairement à la succession des couches, des dimensions de 65 nm x 80 nm à 350 nm x 400 nm et, parallèlement à la succession des couches, une épaisseur de 2 à 20 nm.

4. Elément magnétorésistant, dans lequel
- un premier élément (31) ferromagnétique sous forme de couche, un élément (33) amagnétique sous forme de couche et un deuxième élément (32) ferromagnétique sous forme de couche sont prévus, qui sont superposées en une pile, de façon à ce que l'élément amagnétique sous forme de couche soit interposé entre le premier élément ferromagnétique sous forme de couche et le deuxième élément ferromagnétique sous forme de couche, l'élément amagnétique sous forme de couche ayant, par rapport au premier élément ferromagnétique sous forme de couche et par rapport au deuxième élément ferromagnétique sous forme de couche, respectivement une interface,
- le premier élément ferromagnétique sous forme de couche et le deuxième élément ferromagnétique sous forme de couche sont sensiblement en le même matériau,
**caractérisé en ce que** le premier élément (31) ferromagnétique sous forme de couche, l'élément (33) amagnétique sous forme de couche et le deuxième élément (32) ferromagnétique sous forme de couche sont respectivement en forme de cylindres creux,
le diamètre extérieur et/ou le diamètre intérieur du premier élément (31) ferromagnétique sous forme de couche diffère du diamètre extérieur ou du diamètre intérieur du deuxième élément (32) ferromagnétique sous forme de couche et le premier élément (31) ferromagnétique sous forme de couche, l'élément (33) amagnétique sous forme de couche et le deuxième élément (32) ferromagnétique sous forme de couche étant empilés dans la direction des axes principaux des cylindres creux.

5. Elément magnétorésistant suivant la revendication 4, dans lequel les épaisseurs du premier élément (31) ferromagnétique sous forme de couche et du deuxième élément (32) ferromagnétique sous forme de couche sont respectivement de 2 nm à 20 nm et
les diamètres extérieurs du premier élément ferromagnétique sous forme de couche et du deuxième élément ferromagnétique sous forme de couche sont compris entre 50 nm et 400 nm environ,
les diamètres extérieurs et/ou les diamètres intérieurs du premier élément ferromagnétique sous forme de couche et du deuxième élément ferromagnétique sous forme de couche différents de 20 pour cent à 50 pour cent.

6. Elément magnétorésistant suivant la revendication 4, dans lequel le diamètre extérieur du premier élément (31) ferromagnétique sous forme de couche est compris entre 75 nm et 300 nm et l'épaisseur du premier élément (31) ferromagnétique sous forme de couche, parallèlement à l'axe principal, est comprise entre 2 nm et 20 nm et
le diamètre extérieur du deuxième élément (32) ferromagnétique sous forme de couche est compris entre 100 nm et 400 nm et l'épaisseur du deuxième élément (32) ferromagnétique sous forme de couche, parallèlement à l'axe principal du cylindre, est comprise entre 2 nm et 20 nm.

7. Elément magnétorésistant, dans lequel
- un premier élément (41) ferromagnétique sous forme de couche, un élément (43) amagnétique sous forme de couche et un deuxième élément (42) ferromagnétique sous forme de couche sont prévus, qui sont disposés de façon à ce que l'élément amagnétique sous forme de couche soit interposé entre le premier élément ferromagnétique sous forme de couche et le deuxième élément ferromagnétique sous forme de couche, l'élément amagnétique sous forme de couche ayant, par rapport au premier élément ferromagnétique sous forme de couche et par rapport au deuxième élément ferromagnétique sous forme de couche, respectivement une interface, et
- le premier élément ferromagnétique sous forme de couche et le deuxième élément ferromagnétique sous forme de couche sont sensiblement en le même matériau,
**caractérisé en ce que** le premier élément (41) ferromagnétique sous forme de couche, l'élément (43) amagnétique sous forme de couche et le deuxième élément (42) ferromagnétique sous forme de couche sont respectivement en forme de cylindres creux,
le premier élément (41) ferromagnétique sous forme de couche, l'élément (43) amagnétique sous forme de couche et le deuxième élément (42) ferromagnétique sous forme de couche étant disposés de manière concentrique les uns par rapport aux autres, l'élément (43) amagnétique sous forme de couche étant disposé en direction radiale par rapport au cylindre creux entre le premier élément (41) ferromagnétique sous forme de couche et le deuxième élément (42) ferromagnétique sous forme de couche, et
le premier élément (41) ferromagnétique sous forme de couche et le deuxième élément (42) ferromagnétique sous forme de couche étant différents pour ce qui concerne leur hauteur parallèlement à l'axe principal du cylindre.

8. Elément magnétorésistant suivant la revendication 7, dans lequel
la hauteur du premier élément (41) ferromagnétique sous forme de couche est comprise entre 50 nm et 250 nm,
la hauteur du deuxième élément (42) ferromagnétique sous forme de couche est comprise entre 80 nm et 400 nm et
la différence de hauteur est comprise entre 30 nm et 150 nm.

9. Elément magnétorésistant suivant la revendication 7, dans lequel le premier élément (41) ferromagnétique sous forme de couche a un diamètre extérieur compris entre 70 nm et 400 nm, un diamètre intérieur compris entre 60 nm et 390 nm et une hauteur, parallèlement à l'axe principal du cylindre, comprise entre 35 nm et 180 nm,
le deuxième élément (42) ferromagnétique sous forme de couche a un diamètre extérieur compris entre 60 nm et 390 nm, un diamètre intérieur compris entre 50 nm et 380 nm et une hauteur, parallèlement à l'axe principal du cylindre, comprise entre 50 nm et 400 nm.

10. Elément magnétorésistant suivant l'une des revendications 1 à 9, dans lequel
l'élément (13, 23, 33, 43) amagnétique sous forme de couche comprend au moins l'un des matériaux NiO, HfO₂, TiO₂, NbO, SiO₂ et a une épaisseur comprise entre environ 1 nm et 4 nm.

11. Elément magnétorésistant suivant l'une des revendications 1 à 10, dans lequel
le premier élément (11, 21, 31, 41) ferromagnétique sous forme de couche et le deuxième élément (12, 22, 32, 42) ferromagnétique sous forme de couche comprennent respectivement au moins l'un des éléments Cr, Mn, Gd, Dy.
